Europäisches Patentamt

European Patent Office

Office européen des brevets

(11) Publication number: 0 180 419
A2

# EUROPEAN PATENT APPLICATION

(21) Application number: 85307701.4

(22) Date of filing: 24.10.85

(51) Int. Cl.4: G03F 5/20 , B41M 1/10

(30) Priority: 29.10.84 JP 227346/84

(43) Date of publication of application:
07.05.86 Bulletin 86/19

(84) Designated Contracting States:
AT BE CH DE FR GB IT LI LU NL SE

(71) Applicant: DAIICHI MACHINERY SERVICE CO. LTD.
3-20, Kandanishiki-cho Chiyoda-ku
Tokyo(JP)

(72) Inventor: Tobita, Joji c/o Daiichi Machinery Service
Co. Ltd
3-20, Kandanishiki-cho
Chiyoda-ku Tokyo(JP)
Inventor: Sugasawa, Takashiki Daiichi Mach. Service
Co. Ltd
3-20, Kandanishiki-cho
Chiyoda-ku Tokyo(JP)

(74) Representative: Gillam, Francis Cyril et al
Sanderson & Co. 97 High Street
Colchester Essex C01 1TH(GB)

(54) Printing method and plate.

(57) An intaglio plate for a pad or gravure printing method
comprises a base plate 1 having a flat-bottomed recess 2
formed in the surface thereof. A resin intaglio printing plate 4
is securely attached within the recess to the base plate, that
printing plate having the design to be printed formed therein
for example by a photographic process. The upper surface of
the resin plate is substantially co-planar with or just below the
surface of the base plate 1, so that when the intaglio plate is
doctored by means of a suitable doctor blade, the pressure
force of the doctor blade is borne largely by the base plate
and not by the resin plate.

FIG.6

EP 0 180 419 A2

## PRINTING METHOD AND PLATE

This invention relates to a printing method and printing plate. More particularly, this invention relates to a pad or gravure printing method including the step of doctoring an intaglio plate by reciprocating a doctor blade over the plate. Furthermore, the invention also relates to an intaglio printing plate for use in a pad or gravure printing method where a design to be printed is formed in a surface of a printing plate which subsequently is inked and doctored.

Conventionally, intaglio printing is performed using an etched steel printing plate. However, the manufacture of such a plate involves relatively high plate-making costs, and so is commercially disadvantageous. Hence, it has been proposed to replace steel intaglio plates with photo-sensitive resin plates, such resin plates being mounted on a suitable rigid base to permit satisfactory printing.

In intaglio printing, the printing ink on the non-etched surface portions of the intaglio plate must be scraped off by means of a doctor blade. When a resin plate is employed in an intaglio printing process, the resin plate presents a problem in terms of its durability though it is advantageous with respect to the plate-making cost, as compared with a plate of a harder material such as a steel plate.

Another problem which occurs with the use of a photo-sensitive resin plate is that the limited hardness of the plate is not sufficient to be able to bear the pressure of the doctor blade in the event of a design to be printed having thick lines or areas of solid colour, since the non-etched regions are then of a relatively small size.

It is therefore a principal object of this invention to provide a printing method and printing plate which solve the problems associated with the prior art as discussed above.

Accordingly, one aspect of this invention provides a pad or gravure printing method including the step of doctoring an intaglio plate by moving a doctor blade over the plate, characterised in that the intaglio plate is produced by firmly attaching a resin intaglio plate within a recess formed in the surface of a base plate, and in that the pressure of the doctor blade is mainly borne by the surface of the base plate around the recess therein as the blade scrapes printing ink off the resin plate.

In a printing process of this invention, when the doctor blade is moved by being reciprocated over the intaglio plate to scrape printing ink off the plate, the pressing force of the doctor blade is largely borne by the surface of the metal base plate around the recess therein, so that the resin intaglio plate is protected from damage and wear by the doctor blade movement.

Most preferably, the upper surface of the resin intaglio plate is co-planar with the base plate surface having the recess formed therein, or is just below that surface, to allow for bending of the doctor blade.

The resin intaglio plate could have the design to be be printed formed therein by any suitable method prior to the resin plate being secured within the recess, but it is most advantageous for a photosensitive resin material to be used, which is secured within the base plate recess either in sheet or in liquid form, and subsequently the required design is produced in the resin by a photographic process.

According to a further aspect of this invention, there is provided an intaglio printing plate for use in a pad or gravure printing method where a design to be printed is formed in a surface of a printing plate which subsequently is inked and doctored, characterised in that the printing plate comprises a base plate having a recess formed in a surface thereof, and a resin intaglio plate disposed within and firmly attached to the recess in the base plate.

Most preferably the recess in the base plate is surrounded on all sides by marginal regions of the base plate surface.

The recess is advantageously of a substantially uniform depth. This permits the use of a sheet-like film resin plate to be used. The base plate itself could be planar, or cylindrical, especially when a gravure printing process is to be employed.

It will be appreciated that when using a printing plate according to this invention, areas of solid printing can be adequately accomplished. Also, the durability of the resin plate can greatly be improved, as compared to known resin plates, and the production costs of intaglio plate of the prior art can be reduced.

By way of example of this invention, a specific process thereof will now be described, reference being made to the accompanying drawings, in which:

Figure 1 illustrates the application of a liquid resin in a recess in a base plate for making a printing plate according to this invention;

Figure 2 illustrates the step of forming a resin layer with a sheet-like resin film;

Figure 3 illustrates an exposure step in the process of this invention; and

Figure 4 shows a water spraying step, utilised after the exposure step;

Figure 5 is an illustration of a further exposure step in the process of this invention;

Figure 6 shows a doctoring step using a resin intaglio plate according to this invention; and

Figure 7 shows the present invention as applied to a gravure printing process using a cylindrical intaglio plate.

The intaglio plate used in the printing method of this invention can be prepared by just firmly and securely attaching a separately prepared intaglio plate made of a resin material to a flat-bottomed recess formed in the surface of a suitable base plate. However, the intaglio plate may instead be prepared in the following manner.

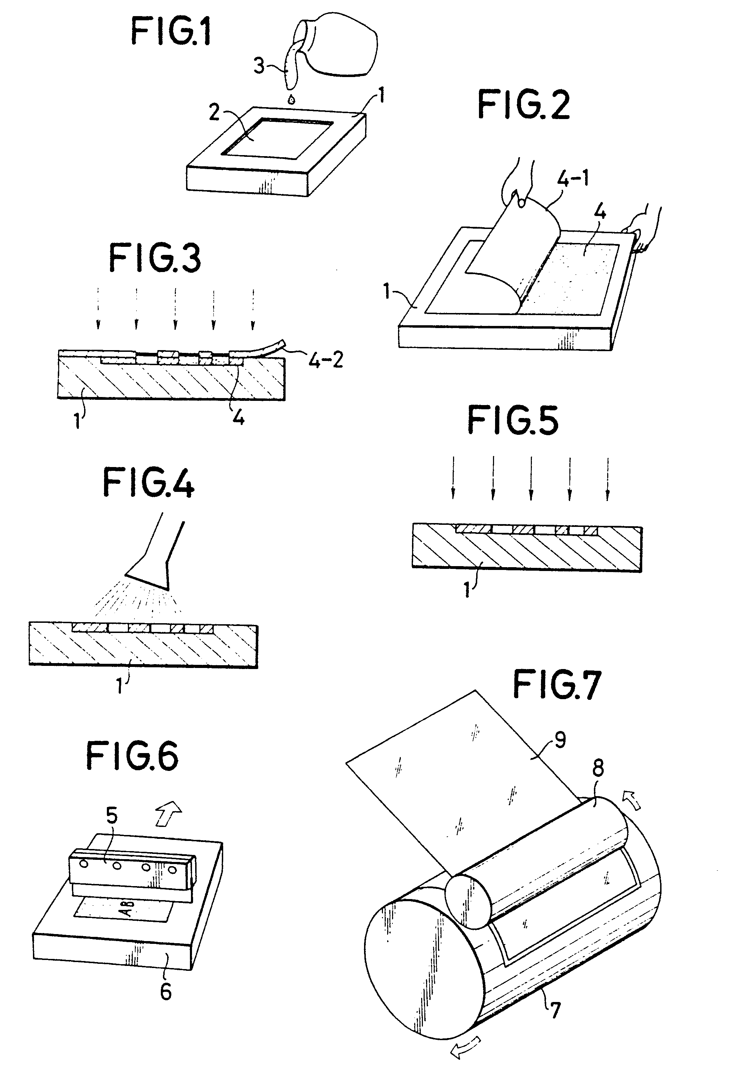

Referring to Figure 1, base plate 1 is made of the same material as a conventional steel printing plate. A flat-bottomed recess 2 is formed in the surface of the base plate 1 by a suitable process such as etching or engraving, so as to have a uniform depth. The recess could instead be formed by metal plating the marginal region around the recess. A photo-sensitive liquid resin 3 is poured into this recess 2, and surplus resin upstanding beyond the surface level (i.e. the edges) of the base plate is scraped and levelled off by means of a doctor blade or the like, to obtain a flat resin layer. As an alternative, a sheet of photo-sensitive resin film 4, which is coated on a base sheet film 4-1 is pressed, with the use of an adhesion promoting solution such as alcohol or with heating, against the bottom face of the recess 2 by means of a roller or the like and, after the film 4 has thus been firmly attached to the bottom face, the base sheet film 4-1 is peeled off as shown in Figure 2.

The resin for use in producing the intaglio plate according to this invention may be selected from those resin materials used for conventional relief printing plates or intaglio plates, such as SILUPICA, a trade name of a product of DAICEL CHEMICAL INDUSTRIES LIMITED.

When the photo-sensitive resin layer has been formed in the described manner, it is checked for any air bubbles and dust remaining between the layer and the bottom of the recess in the base plate. After that, an etching operation including the steps of exposure through a pattern mask 4-2, development and so on is carried out on the photo-sensitive resin layer, as shown in Figures 3 and 4. In this way, a resin intaglio plate is obtained.

The depth of the flat-bottomed recess to be formed in the surface of the base plate depends on the thickness of the resin plate which is to be secured therein, and is determined to be such a depth that the surface of the resin intaglio plate is just lower than the surface of the base plate.

The spacing between the resin plate surface and the base plate surface is normally necessary because the doctor blade will bend slightly where not supported by the base plate. The spacing will depend upon various factors including the thickness of the blade, the force pressing the blade on to the base plate, the contact angle between the blade and the base plate, and the width of the recess. For example, when the width of the recess is about 60 mm, the spacing desirably is about 2 to 5 micron.

In carrying out the exposure process, a positive film 4-2 of a design to be developed in the intaglio plate is laid on the photo-sensitive resin layer and then an exposure is effected through the positive film. The length of time required for the exposure varies with the kind of light source employed. However, an exposure period of between 30 sec and 3 min should suffice in the case of a UV discharge lamp. After completion of the exposure, a development process is carried out by applying water or developing solution by spraying or brushing to wash away resin from the unexposed parts of the resin layer (Figure 4). After development, all water is removed from the surface of the plate. If necessary, the remaining exposed parts of the design may be subjected to another exposure process (for a period of 5 to 15 minutes) until the remaining parts come to have a desired degree of hardness. The hardening exposure process may be followed by or replaced by a process using a hardening agent.

As shown in Figure 7, the present invention is applicable to a gravure printing process where a cylindrical intaglio plate is used. As shown, the recess is formed on the surface of the cylindrical intaglio plate, and the photo-sensitive resin sheet is inserted between the cylinder and a transfer roller 8, which presses on the cylinder and transfers the resin into the recess. The exposure may be performed by a conventional method as used in the gravure printing art.

In order to perform printing using an intaglio plate 6 produced as described in the foregoing, ink is applied in a suitable manner to the intaglio plate and then a doctor blade 5 is moved over the entire plate 6, including the edge portions of the base plate, as shown in Figure 6. In this way, excess ink is scraped off the plate by the doctor blade 5, leaving ink in the recesses of the resin intaglio plate. The scraping pressure of the doctor blade during this is mainly borne by the edge portions of the base plate remaining around the recessed resin intaglio plate. Therefore, the entire pressing force of the doctor blade is not directly exerted on the resin intaglio plate and that plate is saved from wear and damage as a consequence of the pressing force.

It will be appreciated that printing may be accomplished by using an intaglio printing plate of this invention incorporated within a conventional steel plate, part only of the design to be printed being in the resin plate with the remainder in the steel plate. This enables the present invention to be used for cases where said part of the design to be printed must frequently be rearranged, for example when date codes or other design elements are printed. The conventional steel plate arrangement incorporates those parts of the design which do not require frequent rearrangement.

Another advantage of the invention is that the photosensitive resin intaglio plate can be prepared at a very low cost.

## Claims

1. A pad or gravure printing method including the step of doctoring an intaglio plate by moving a doctor blade over the plate, characterised in that the intaglio plate is produced by firmly attaching a resin intaglio plate within a recess formed in the surface of a base plate, and in that the pressure of the doctor blade is mainly borne by the surface of the base plate around the recess therein as the blade scrapes printing ink off the resin plate.

2. A pad or gravure printing method according to claim 1, characterised in that the upper surface of the resin intaglio plate is co-planar with or just below the plane of the base plate surface having the recess formed therein.

3. A pad or gravure printing method according to claim 1 or claim 2, characterised in that the design to be printed is formed in the resin intaglio plate by a photographic process, the resin used to produce the intaglio plate being photosensitive.

4. A pad or gravure printing method according to claim 3, characterised in that a plain photosensitive resin material is deposited in the recess in the base plate, and subsequently the required design is produced in the resin by a photographic process.

5. A pad or gravure printing method according to any of the preceding claims, characterised in that the recess in the base plate is of substantially uniform depth over the entire area thereof, a pre-formed sheet-like resin intaglio plate being attached within the recess.

6. A pad or gravure printing method according to any of the preceding claims, characterised in that the recess in the base plate is produced by an etching step.

7. An intaglio printing plate for use in a pad or gravure printing method where a design to be printed is formed in a surface of a printing plate which subsequently is inked and doctored, characterised in that the printing plate comprises a base plate having a recess formed in a surface thereof, and a resin intaglio plate disposed within and firmly attached to the recess in the base plate.

8. An intaglio printing plate according to claim 7, further characterised in that the recess in the base plate is surrounded on all sides by marginal regions of the base plate surface.

9. An intaglio printing plate according to claim 7 or claim 8, characterised in that the recess in the base plate is of substantially uniform depth over the whole area thereof, the resin intaglio plate being pre-formed from a sheet of resin material to fit with the recess.

10. An intaglio printing plate according to any of claims 7 to 9, characterised in that the base plate is either of planar or of cylindrical form.

0 180 419

FIG.1

FIG.2

FIG.3

FIG.4

FIG.5

FIG.6

FIG.7